# EUROPÄISCHE PATENTSCHRIFT

(11) **EP 2 281 314 B1**
(45) Veröffentlichungstag und Bekanntmachung des Hinweises auf die Patenterteilung: **15.07.2015**
(21) Anmeldenummer: 09749481.9
(22) Anmeldetag: 24.04.2009
(51) Int. Cl.: H01L 33/38, H01L 33/40, H01L 33/44

(54) **OPTOELEKTRONISCHER HALBLEITERCHIP MIT EINER REFLEKTIERENDEN SCHICHT**
OPTOELECTRONIC SEMICONDUCTOR CHIP COMPRISING A REFLECTIVE LAYER
PUCE SEMI-CONDUCTRICE OPTOÉLECTRONIQUE COMPRENANT UNE COUCHE RÉFLECTRICE

(30) Priorität: 20.05.2008 DE 102008024327
(43) Veröffentlichungstag der Anmeldung: 09.02.2011
(73) Patentinhaber: OSRAM Opto Semiconductors GmbH, 93055 Regensburg (DE)
(72) Erfinder: ALBRECHT, Tony, 93077 Bad Abbach (DE); WEIMAR, Andreas, 93055 Regensburg (DE); KASPRZAK-ZABLOCKA, Anna, 93093 Donaustauf (DE); EICHINGER, Christian, 93173 Wenzenbach (DE); NEVELING, Kerstin, 93059 Regensburg (DE)
(74) Vertreter: Epping - Hermann - Fischer
(86) Internationale Anmeldenummer: PCT/DE2009/000576
(87) Internationale Veröffentlichungsnummer: WO 2009/140939

(56) Entgegenhaltungen:
- EP-A- 1 583 159
- DE-A1-102004 040 277
- JP-A- 2004 047 504
- JP-A- 2005 101 212
- US-A1- 2007 290 215

## Beschreibung

Die Druckschrift US 7,265,392 beschreibt einen optoelektronischen Halbleiterchip mit einer silberhaltigen reflektierenden Schicht.

Die Druckschrift JP-A-2005 101 212 beschreibt einen optoelektronischen Halbleiterchip mit einer Spiegelschicht an den Chipflanken.

Die Druckschrift JP-A-2004 047 504 beschreibt einen optoelektronischen Halbleiterchip.

Die Druckschrift US 2007/ 0 290 215 beschreibt einen optoelektronischen Halbleiterchip nach dem Oberbegriff des Patentanspruchs 1.

Eine zu lösende Aufgabe besteht darin, einen optoelektronischen Halbleiterchip anzugeben, der eine besonders hohe Lebensdauer aufweist. Eine weitere zu lösende Aufgabe besteht darin, einen optoelektronischen Halbleiterchip anzugeben, der besonders einfach herstellbar ist. Eine weitere zu lösende Aufgabe besteht darin, optoelektronischen Halbleiterchip anzugeben, der besonders effizient ist.

Die Erfindung betrifft einen optoelektronischen Halbleiterchip nach Anspruch 1.

Es wird ein optoelektronischer Halbleiterchip angegeben. Bei dem optoelektronischen Halbleiterchip handelt es sich beispielsweise um einen Lumineszenzdiodenchip. Bei dem Lumineszenzdiodenchip kann es sich um einen Laserdiodenchip oder bevorzugt um einen Leuchtdiodenchip handeln. Ferner ist es möglich, dass es sich bei dem optoelektronischen Halbleiterchip um einen Detektorchip, wie beispielsweise einen Fotodiodenchip, handelt.

Gemäß zumindest einer Ausführungsform des optoelektronischen Halbleiterchips weist dieser eine erste Kontaktstelle und eine zweite Kontaktstelle auf. Der optoelektronische Halbleiterchip kann über die Kontaktstellen mit einem elektrischen Strom zum Betrieb des optoelektronischen Halbleiterchips beaufschlagt werden. Bei der ersten Kontaktstelle handelt es sich beispielsweise um einen n-Kontakt des Halbleiterchips. Bei der zweiten Kontaktstelle handelt es sich dann um einen p-Kontakt des Halbleiterchips. Die erste Kontaktstelle kann beispielsweise durch ein Bondpad gebildet sein. Die zweite Kontaktstelle kann durch eine Lotmetallisierung gebildet sein.

Gemäß zumindest einer Ausführungsform des optoelektronischen Halbleiterchips umfasst der optoelektronische Halbleiterchip eine reflektierende Schicht. Die reflektierende Schicht ist vorgesehen, im optoelektronischen Halbleiterchip erzeugte oder im optoelektronischen Halbleiterchip zu detektierende elektromagnetische Strahlung zu reflektieren.

Die reflektierende Schicht ist dabei vorzugsweise direkt elektrisch leitend an die zweite Kontaktstelle angeschlossen. "Direkt elektrisch leitend" heißt dabei, dass sich beispielsweise kein Halbleitermaterial zwischen der zweiten Kontaktstelle und der reflektierenden Schicht befindet, sondern die reflektierende Schicht und die zweite Kontaktstelle in direktem Kontakt zueinander stehen oder durch ein gut leitendes Material - wie ein Metall - miteinander verbunden sind.

Bei der reflektierenden Schicht kann es sich um einen Spiegel handeln. Die reflektierende Schicht weist für im Halbleiterchip erzeugte oder zu detektierende elektromagnetische Strahlung vorzugsweise eine Reflektivität von wenigstens 80%, bevorzugt von wenigstens 90% auf.

Die reflektierende Schicht enthält ein zur Migration neigendes Metall. "Ein zur Migration neigendes Metall" heißt, dass das Metall in einem äußeren elektrischen Feld zu einer Bewegung oder einer Diffusion neigt, die durch das äußere elektrische Feld getrieben ist. Mit anderen Worten wirkt auf Grund des elektrischen Feldes eine Kraft auf das Metall in der reflektierenden Schicht, die zur Herauslösung von Metall aus der reflektierenden Schicht führen kann.

Beispielsweise Ionen des Metalls können sich dann entlang der Feldlinien bewegen und können durch diese Migration in Bereiche des optoelektronischen Halbleiterchips gelangen, wo sie Schaden verursachen. Ferner ist es möglich, dass das zur Migration neigende Metall aufgrund der Migrationsbewegung im elektrischen Feld aus dem Halbleiterchip hinaus in beispielsweise ein Gehäuse für den optoelektronischen Halbleiterchip gelangt, wo es ebenfalls Schaden verursachen kann.

Der verursachte Schaden kann beispielsweise in einem Kurzschluss des optoelektronischen Halbleiterchips bestehen. Ferner wird durch die Migration im elektrischen Feld - das heißt die Elektromigration - aus der reflektierenden Schicht hinaus die reflektierende Schicht geschädigt, sodass ihre elektrischen und optischen Eigenschaften negativ beeinflusst werden. Das Problem der Neigung zur Migration im elektrischen Feld tritt dabei insbesondere auch bei feuchter Umgebung auf. Insgesamt reduziert die Migration des Metalls aus der reflektierenden Schicht die Lebensdauer des optoelektronischen Halbleiterchips.

Bei dem zur Migration neigenden Metall handelt es sich beispielsweise um Silber. In diesem Fall neigen dann Silberionen zur Migration entlang elektrischer Feldlinien im optoelektronischen Halbleiterchip. Ferner ist es möglich, dass es sich bei dem zur Migration neigenden Metall um ein anderes Metall wie beispielsweise Kupfer oder Nickel handelt.

Gemäß zumindest einer Ausführungsform ist die reflektierende Schicht im optoelektronischen Halbleiterchip derart angeordnet, dass sich für das zur Migration neigende Metall ein Migrationspfad zwischen der zweiten und der ersten Kontaktstelle ausbilden kann. Beispielsweise grenzt die reflektierende Schicht direkt an einen Halbleiterkörper des optoelektronischen Halbleiterchips. Erste und zweite Kontaktstellen sind mit dem Halbleiterkörper dann elektrisch leitend verbunden. Aufgrund der elektrisch leitenden Verbindung zwischen der zweiten Kontaktstellen und der reflektierenden Schicht kann sich dann ein Migrationspfad im Halbleiterkörper zwischen der ersten und der zweiten Kontaktstelle ausbilden.

Das Vorhandensein eines Migrationspfades bedeutet also, dass im optoelektronischen Halbleiterchip insbesondere keine Migrationssperre oder Migrationsbarriere vorhanden ist, die das zur Migration neigende Metall aus der reflektierenden Schicht an einer Migration im optoelektronischen Halbleiterchip hindern könnte. Der optoelektronische Halbleiterchip ist also frei von einer Migrationsbarriere für eine Migration des zur Migration neigenden Metalls aus der reflektierenden Schicht. Der Verzicht auf eine solche Migrationsbarriere resultiert in einem optoelektronischen Halbleiterchip, der besonders einfach und damit kostengünstig herstellbar ist.

Gemäß zumindest einer Ausführungsform des optoelektronischen Halbleiterchips ist am Halbleiterchip ein Mittel vorgesehen, das im Betrieb des Halbleiterchips ein elektrisches Feld ausbildet, das der Migration des Metalls entgegenwirkt. Das heißt, im Betrieb des Halbleiterchips ist zum einen ein elektrisches Feld zwischen der ersten und der zweiten Kontaktstelle vorhanden, das die Elektromigration von Metall aus der reflektierenden Schicht im optoelektronischen Halbleiterchip begünstigt. Diesem elektrischen Feld wirkt das Mittel im Halbleiterchip entgegen, das seinerseits ein elektrisches Feld ausbildet, das der Migration des Metalls entgegenwirkt.

Mit anderen Worten wird das Herauslösen des Metalls aus der reflektierenden Schicht und die Migration des Metalls im optoelektronischen Halbleiterchip verhindert oder zumindest gehemmt, indem insbesondere kritische Stellen des Halbleiterchips, in denen eine Migration von dem Metall verstärkt stattfinden würde, durch das elektrische Feld abgeschirmt werden. Das heißt, bei vorliegendem optoelektronischen Halbleiterchip wird die reflektierende Schicht nicht mit beispielsweise Dielektrika oder metallischen Sperren als Migrationsbarrieren gekapselt, sondern das Unterbinden der Migration erfolgt durch das Abschirmen des im Halbleiterchip anliegenden elektrischen Feldes beziehungsweise ein elektrisches Gegenfeld.

Gemäß zumindest einer Ausführungsform des optoelektronischen Halbleiterchips umfasst der optoelektronische Halbleiterchip eine erste und eine zweite Kontaktstelle sowie eine reflektierende Schicht, die direkt elektrisch leitend an die zweite Kontaktstelle angeschlossen ist, wobei die reflektierende Schicht ein zur Migration neigendes Metall enthält und die reflektierende Schicht derart angeordnet ist, dass sich für das Metall ein Migrationspfad zwischen der zweiten und der ersten Kontaktstelle ausbilden kann. Am Halbleiterchip ist dabei ein Mittel vorgesehen, das im Betrieb des Halbleiterchips ein elektrisches Feld ausbildet, das der Migration des Metalls entgegenwirkt. Dieses Mittel kann beispielsweise randseitig am optoelektronischen Halbleiterchip angeordnet sein. Ferner ist es möglich, dass es zumindest stellenweise auch im Halbleiterchip angeordnet ist.

Gemäß zumindest einer Ausführungsform des optoelektronischen Halbleiterchips ist das Mittel mit einem elektrisch leitenden Material gebildet, das sich zwischen der ersten und der zweiten Kontaktstelle erstreckt. Das elektrisch leitende Material ist dabei direkt elektrisch leitend mit der zweiten Kontaktstelle verbunden. Das heißt, es gibt eine direkte elektrische Anbindung des elektrisch leitenden Materials an die zweite Kontaktstelle. Das elektrisch leitende Material und die zweite Kontaktstelle berühren sich beispielsweise oder sind durch eine gute elektrische Verbindung - beispielsweise eine metallische Verbindung - miteinander verbunden. Das Material ist dabei derart am Halbleiterchip angeordnet, dass es sich zwischen der ersten und der zweiten Kontaktstelle erstreckt. Das heißt, das Material erstreckt sich zumindest stellenweise in Richtung des Migrationspfads für das zur Migration neigende Metall aus der reflektierenden Schicht.

Gemäß zumindest einer Ausführungsform des optoelektronischen Halbleiterchips umfasst der optoelektronische Halbleiterchip einen Halbleiterkörper, an dessen Oberseite die erste Kontaktstelle und an dessen Unterseite die zweite Kontaktstelle angeordnet ist. Der optoelektronische Halbleiterchip umfasst ferner eine reflektierende Schicht, die sich in direktem Kontakt mit dem Halbleiterkörper befindet. Beispielsweise ist die reflektierende Schicht an die Unterseite des Halbleiterkörpers aufgebracht und grenzt an der Unterseite des Halbleiterkörpers direkt an diesen. Dabei ist es möglich, dass die reflektierende Schicht eine Bodenfläche des Halbleiterkörpers vollständig bedeckt. Ferner ist es möglich, dass die reflektierende Schicht strukturiert auf die Bodenfläche des Halbleiterkörpers aufgebracht ist. Die reflektierende Schicht befindet sich in direktem elektrischen Kontakt mit der zweiten Kontaktstelle, das heißt sie ist direkt leitend mit der zweiten Kontaktstelle verbunden.

Beispielsweise grenzt die zweite Kontaktstelle direkt an die reflektierende Schicht. Die reflektierende Schicht ist dann zwischen der zweiten Kontaktstelle und dem Halbleiterkörper angeordnet. Durch die Anordnung der reflektierenden Schicht zwischen der zweiten Kontaktstelle und dem Halbleiterkörper sowie den direkten Kontakt zwischen der reflektierenden Schicht und dem Halbleiterkörper ergibt sich ein Migrationspfad für zur Migration neigendes Metall aus der reflektierenden Schicht in den Halbleiterkörper hinein oder an Randflächen des Halbleiterkörpers. Der Migrationspfad verläuft beispielsweise zwischen der zweiten Kontaktstelle und der ersten Kontaktstelle, die an der Oberseite des Halbleiterkörpers angeordnet ist.

Der optoelektronische Halbleiterchip umfasst ferner zumindest eine Chipflanke, die durch eine Seitenfläche des Halbleiterkörpers gebildet sein kann. Die Chipflanke erstreckt sich dabei zwischen der Oberseite und der Unterseite des Halbleiterkörpers. Die Chipflanke kann eine Randfläche des Halbleiterchips bilden. An der Chipflanke ist das elektrisch leitende Material angeordnet, das mit der zweiten Kontaktstelle direkt elektrisch leitend verbunden ist. Das heißt, das Mittel, das im Betrieb des Halbleiterchips ein elektrisches Feld ausbildet, ist mit dem elektrisch leitenden Material gebildet, das sich an der Chipflanke befindet. Da die Chipflanke zwischen Oberseite und Unterseite des Halbleiterkörpers angeordnet ist und die erste Kontaktstelle an der Oberseite des Halbleiterkörpers und die zweite Kontaktstelle an der Unterseite des Halbleiterkörpers angeordnet ist, erstreckt sich das elektrisch leitende Material an der Chipflanke, also zwischen der ersten und der zweiten Kontaktstelle.

Gemäß zumindest einer Ausführungsform des optoelektronischen Halbleiterchips ist das elektrisch leitende Material dabei nicht direkt auf die Chipflanke aufgebracht, sondern zwischen der Chipflanke und dem elektrisch leitenden Material befindet sich ein elektrisch isolierendes Material, das eine Kontaktierung des Halbleiterkörpers durch das elektrisch leitende Material verhindert. Das Mittel, das im Betrieb des Halbleiterchips ein elektrisches Feld ausbildet, ist in diesem Fall aus dem elektrisch isolierenden Material und dem auf dem elektrisch isolierenden Material angeordneten elektrisch leitenden Material gebildet, das direkt elektrisch leitend mit der zweiten Kontaktstelle verbunden ist. Das elektrisch isolierende Material sorgt dabei dafür, dass das elektrisch leitende Material insbesondere eine aktive, zur Strahlungserzeugung oder Strahlungsdetektion vorgesehene Zone des optoelektronischen Halbleiterkörpers nicht kurzschließt.

Gemäß zumindest einer Ausführungsform des optoelektronischen Halbleiterchips befindet sich im Betrieb des Halbleiterchips die erste Kontaktstelle auf einem ersten elektrischen Potential. Das kann beispielsweise dadurch erreicht sein, dass die erste elektrische Kontaktstelle den n-seitigen Kontakt des Halbleiterkörpers bildet. Die erste Kontaktstelle ist dann an den Minus-Pol einer Spannungsquelle angeschlossen.

Ferner befinden sich die zweite Kontaktstelle, die reflektierende Schicht sowie das elektrisch leitende Material auf einem gemeinsamen zweiten elektrischen Potential. Dies ist dadurch erreicht, dass sowohl die reflektierende Schicht als auch das elektrisch leitende Material direkt elektrisch leitend mit der zweiten Kontaktstelle verbunden sind. Die zweite Kontaktstelle kann dann beispielsweise an den Plus-Pol der Spannungsquelle angeschlossen sein.

Auf diese Weise befinden sich die erste elektrische Kontaktstelle zum einen und die zweite Kontaktstelle, die reflektierende Schicht und das elektrisch leitende Material zum anderen auf zwei voneinander verschiedenen ersten und zweiten elektrischen Potentialen. Aufgrund der Anordnung des elektrisch leitenden Materials zwischen der ersten und zweiten Kontaktstelle und der Tatsache, dass sich das elektrisch leitende Material auf einem gemeinsamen elektrischen Potential mit der reflektierenden Schicht und der zweiten Kontaktstelle befindet, wirkt das elektrisch leitende Material als ein Mittel, das im Betrieb des Halbleiterchips ein elektrisches Feld ausbildet, das der Migration des Metalls aus der reflektierenden Schicht, das heißt dem zwischen erster und zweiter Kontaktstelle ausgebildeten elektrischen Feld, entgegenwirkt.

Das elektrisch leitende Material liegt also zwischen der reflektierenden Schicht und dem ersten Kontakt und schirmt das elektrische Feld im Bereich der reflektierenden Schicht ab, sodass beispielsweise Metallionen aus der reflektierenden Schicht nicht zur ersten Kontaktstelle hin gezogen werden.

Gemäß zumindest einer Ausführungsform des optoelektronischen Halbleiterchips enthält die reflektierende Schicht dabei Silber oder sie besteht aus Silber. Silber zeichnet sich dadurch aus, dass es über einen großen Bereich des Spektrums für sichtbares Licht eine hohe Reflektivität aufweist. Ferner zeichnet sich Silber durch eine sehr gute elektrische Leitfähigkeit aus, sodass es als ein elektrischer Kontakt Verwendung finden kann. Silber weist jedoch, insbesondere in Form von Silberionen, eine hohe Neigung zur Migration im elektrischen Feld auf, was den Einsatz von Silber als eine reflektierende Schicht in einem optoelektronischen Halbleiterchip gewöhnlicherweise erschwert oder unmöglich macht.

Gemäß zumindest einer Ausführungsform des optoelektronischen Halbleiterchips ist die reflektierende Schicht derart strukturiert, dass an der Unterseite des Halbleiterkörpers im Bereich der Projektion der ersten Kontaktstelle auf diese Unterseite der Halbleiterkörper frei von der reflektierenden Schicht ist. In diesem Bereich kann beispielsweise zwischen zweiter Kontaktstelle und dem Halbleiterkörper ein elektrisch isolierendes Material angeordnet sein, das eine Bestromung des Halbleiterkörpers in diesem Bereich unterbindet. Dies hat den Vorteil, dass im Bereich der ersten Kontaktstelle kein elektrischer Strom in eine aktive, zur Strahlungserzeugung oder Detektion vorgesehene Zone des Halbleiterkörpers fließen kann, sodass unterhalb der ersten Kontaktstelle keine Strahlung erzeugt wird. Diese Strahlung würde nämlich an der ersten Kontaktstelle absorbiert werden und könnte von daher nicht zur Lichterzeugung oder Lichtdetektion beitragen. Das heißt, dort, wo sich die erste Kontaktstelle befindet, wird in der aktiven Zone keine elektromagnetische Strahlung erzeugt.

Gemäß zumindest einer Ausführungsform des optoelektronischen Halbleiterchips ist um die erste Kontaktstelle herum von der Oberseite des Halbleiterkörpers her ein Graben in den Halbleiterkörper strukturiert. Dieser Graben kann beispielsweise mittels Ätzen strukturiert sein. Er umschließt vorzugsweise die erste Kontaktstelle, die beispielsweise an zentraler Stelle an der Oberseite des Halbleiterkörpers angeordnet ist, vollständig. Mit anderen Worten umläuft der Graben die erste Kontaktstelle beispielsweise ringartig. Der Graben durchtrennt dabei vorzugsweise die aktive Zone. Besonders bevorzugt erstreckt sich der Graben bis zur reflektierenden Schicht. Das heißt, der Graben kann derart tief ausgebildet sein, dass er den Halbleiterkörper von seiner Oberseite bis zu seiner Unterseite vollständig durchtrennt. Ein solch tiefer Graben stellt eine besonders effektive Möglichkeit dar, eine Bestromung der aktiven Zone unterhalb der ersten Halbleiterschicht zu verhindern.

Gemäß zumindest einer Ausführungsform des optoelektronischen Halbleiterchips ist dieser in Dünnfilmbauweise ausgeführt. Das heißt, der optoelektronische Halbleiterchip umfasst einen Halbleiterkörper, der vorzugsweise epitaktisch auf ein Aufwachssubstrat aufgewachsen ist. Das Aufwachssubstrat wird nach dem epitaktischen Wachsen des Halbleiterkörpers vorzugsweise gedünnt, das heißt in seiner Dicke reduziert, oder vollständig vom Halbleiterkörper entfernt. Mit seiner dem ursprünglichen Aufwachssubstrat abgewandten Seite kann der Halbleiterkörper auf einem Träger befestigt sein. Vorzugsweise befindet sich die reflektierende Schicht zwischen dem Träger und dem Halbleiterkörper.

Die Abfolge kann beispielsweise wie folgt sein: Auf eine Montageseite des Trägers folgt die zweite Kontaktstelle, die beispielsweise durch eine Lotmetallisierung gebildet sein kann. Der zweiten Kontaktstelle folgt dann die reflektierende Schicht direkt nach, das heißt die reflektierende Schicht befindet sich in direktem Kontakt mit der zweiten Kontaktstelle. Der reflektierenden Schicht folgt dann vorzugsweise der Halbleiterkörper an ihrer der zweiten Kontaktstelle abgewandten Seite nach. Halbleiterkörper und reflektierende Schicht befinden sich vorzugsweise in direktem Kontakt zueinander. Auf eine Migrationssperre oder eine Migrationsbarriere, welche die Migration von Metallen oder Metallionen aus dem Träger, der zweiten Kontaktstelle und/oder der reflektierenden Schicht in den Halbleiterkörper hinein verhindert, kann aufgrund des Mittels zur Abschirmung des elektrischen Feldes zwischen erster und zweiter Kontaktstelle vorteilhafterweise verzichtet werden.

Im Folgenden wird der hier beschriebene Halbleiterchip anhand von Ausführungsbeispielen und den dazugehörigen Figuren näher erläutert.
- Die Figur 1: zeigt anhand einer schematischen Schnittdarstellung ein erstes Ausführungsbeispiel eines hier beschriebenen optoelektronischen Halbleiterchips mit reflektierender Schicht.
- Die Figur 2: zeigt anhand einer schematischen Schnittdarstellung ein zweites Ausführungsbeispiel eines hier beschriebenen optoelektronischen Halbleiterchips mit einer reflektierenden Schicht.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

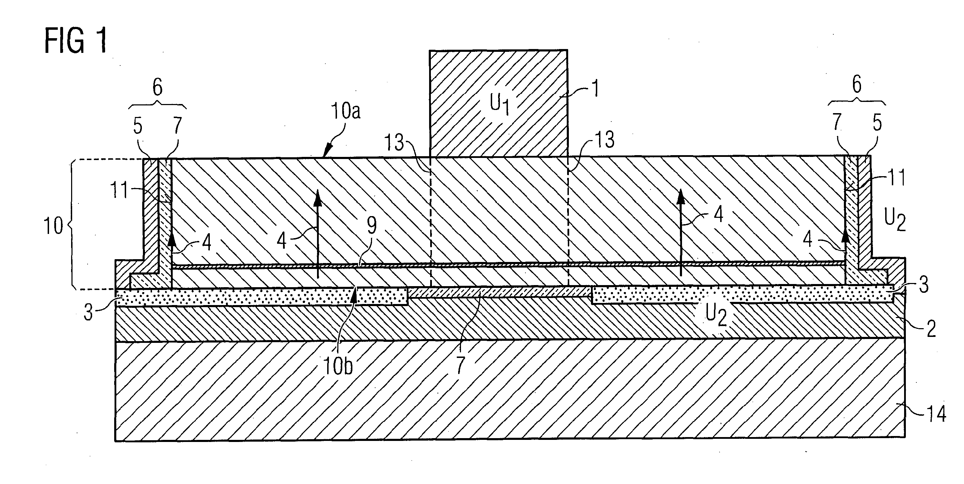

Der in Verbindung mit Figur 1 beschriebene optoelektronische Halbleiterchip ist beispielsweise ein Leuchtdiodenchip, der im Betrieb elektromagnetische Strahlung im sichtbaren Wellenlängenbereich erzeugt. Der optoelektronische Halbleiterchip umfasst einen Halbleiterkörper 10. Der Halbleiterkörper 10 ist vorzugsweise epitaktisch hergestellt. Beispielsweise ist ein Aufwachssubstrat (in der Figur 1 nicht dargestellt) von der Oberseite 10a des Halbleiterkörpers 10 abgelöst. An seiner der Oberseite 10a abgewandten Unterseite 10b ist der Halbleiterkörper 10 auf einen Träger 14 aufgebracht. Der Halbleiterkörper 10 basiert beispielsweise auf einem Nitridverbindungshalbleitermaterial. Der Träger 14 enthält oder besteht aus Germanium.

"Auf Nitridverbindungshalbleitermaterial basierend" bedeutet im vorliegenden Zusammenhang, dass die Halbleiterschichtenfolge oder zumindest ein Teil davon, besonders bevorzugt zumindest die aktive Zone, ein NitridVerbindungshalbleitermaterial, vorzugsweise AlₙGaₘIn₁₋ₙ₋ₘN aufweist oder aus diesem besteht, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt und/oder ergänzt sein können.

Der Halbleiterkörper 10 umfasst eine aktive Zone 9, die bei vorliegendem optoelektronischen Halbleiterchip zur Erzeugung von elektromagnetischer Strahlung geeignet ist. Die aktive Zone 9 umfasst einen pn-Übergang, eine Doppelheterostruktur, einen Einfachquantentopf und/oder einen Mehrfachquantentopf zur Strahlungserzeugung. Die Bezeichnung Quantentopfstruktur beinhaltet dabei keine Angabe über die Dimensionalität der Quantisierung. Sie umfasst somit unter anderem Quantentröge, Quantendrähte und Quantenpunkte und jede Kombination dieser Strukturen.

Der optoelektronische Halbleiterchip umfasst an seiner Oberseite 10a eine erste elektrische Kontaktstelle 1. Bei der ersten elektrischen Kontaktstelle 1 handelt es sich beispielsweise um ein Bondpad zum n-seitigen Kontaktieren des optoelektronischen Halbleiterchips. Die erste Kontaktstelle kann beispielsweise Gold und/oder Aluminium enthalten, oder aus einem dieser Materialien bestehen. Darüber hinaus ist es möglich, dass die erste Kontaktstelle aus wenigstens einem der folgenden Metalle besteht, oder wenigstens eines der folgenden Metalle enthält: Titan, Platin, Chrom, Nickel. Die erste Kontaktstelle kann beispielsweise aus den folgenden Materialkombination bestehen: TiPtAu, CrPtAu, NiAu. Dabei ist es möglich, dass die verschiednen Metalle in Schichten übereinander angeordnet sind.

An der Unterseite 10b des Halbleiterkörpers befindet sich in direktem Kontakt mit dem Halbleiterkörper 10 eine Spiegelschicht 3. Die reflektierende Schicht 3 enthält ein zur Migration neigendes Metall. Die reflektierende Schicht 3 kann dabei eines der folgenden Metalle enthalten oder aus einem der folgenden Metalle bestehen: Aluminium, Platin, Silber. Besonders bevorzugt besteht die reflektierende Schicht 3 aus Silber. Die reflektierende Schicht 3 grenzt unmittelbar an den Halbleiterkörper 10. Das heißt, zwischen reflektierender Schicht 3 und Halbleiterkörper 10 befindet sich beispielsweise keine Migrationsbarriere, das heißt es befindet sich dort keine Schicht, die beispielsweise aus TiWN besteht.

An der dem Halbleiterkörper 10 abgewandten Seite der reflektierenden Schicht 3 befindet sich die zweite Kontaktstelle 2 des optoelektronischen Halbleiterchips. Die zweite Kontaktstelle 2 des optoelektronischen Halbleiterchips ist beispielsweise durch eine Lotmetallisierung gebildet. Materialien für die zweite Kontaktstelle 2 könne etwa Lot-Verbindungen sein, die mit Zinn oder mit Indium gebildet sind. Beispielsweise handelt es sich bei der zweiten Kontaktstelle 2 um eine AuSn-Lotverbindung.

Die zweite Kontaktstelle 2 befindet sich in direktem Kontakt mit der reflektierenden Schicht 3. Die reflektierende Schicht 3 ist in der Projektion 13 der ersten Kontaktstelle 1 auf die Unterseite 10b des Halbleiterkörpers 10 unterbrochen. Das heißt, die reflektierende Schicht 3 ist strukturiert. Die reflektierende Schicht 3 bedeckt den Halbleiterkörper 10 an seiner Unterseite 10b nicht vollständig. Im Bereich der Projektion 13 der ersten Kontaktstelle 1 auf die Unterseite 10b des Halbleiterkörpers 10 befindet sich eine elektrisch isolierende Schicht 7.

Zur Bildung der elektrisch isolierenden Schicht findet vorzugsweise ein Dielektrikum Verwendung. Zum Beispiel kann die isolierende Schicht zumindest eines der folgenden Materialien enthalten: SiNₓ, SiO₂, TiO, Al₂O₃.

Aufgrund der isolierenden Schicht 7 unterhalb der ersten Kontaktstelle 1 wird im Bereich der Projektion 13 auf die aktive Zone 9 dort keine elektromagnetische Strahlung erzeugt. Dies erhöht die Effizienz des optoelektronischen Halbleiterchips, da in diesem Bereich erzeugte elektromagnetische Strahlung den Halbleiterkörper nicht an seiner Oberseite verlassen könnte, da sie von der ersten Kontaktstelle 1 absorbiert wird.

Im Betrieb des optoelektronischen Halbleiterchips befindet sich die erste Kontaktstelle 1 auf einem ersten elektrischen Potential U1 und ist beispielsweise an den Minus-Pol einer Spannungsquelle angeschlossen. Die zweite Kontaktstelle 2 befindet sich auf einem anderen Potential U2 und ist beispielsweise an den Plus-Pol der Spannungsquelle angeschlossen. Die zweite Kontaktstelle 2 befindet sich in direktem elektrischem Kontakt mit der reflektierenden Schicht 3, die aus einem elektrisch leitenden Material besteht. Die reflektierende Schicht 3 befindet sich damit ebenfalls auf dem Potential U2. Aus der Potentialdifferenz zwischen U1 und U2 resultiert ein elektrisches Feld, das beispielsweise auf positiv geladene Metallionen, vorzugsweise Silberionen, aus der reflektierenden Schicht 3 eine Kraft auswirkt, die von der Unterseite 10b zur Oberseite 10a des Halbleiterkörpers 10 gerichtet ist. Im derart gebildeten elektrischen Feld haben die Metallionen eine Neigung zur Migration entlang der Migrationspfade 4.

Die Migration könnte beispielsweise durch den Halbleiterkörper 10 hindurch zum Beispiel entlang von Versetzungen im Halbleiterkörper 10 erfolgen.

Der überwiegende Teil der Migration würde - ohne Gegenmaßnahmen - jedoch entlang von Migrationspfaden 4, die sich entlang der Chipflanken 11 erstrecken erfolgen. Das heißt, das zur Migration neigende Metall - zum Beispiel Silber - migriert an oder über die Chipflanken 11. Das Metall bewegt sich dort entlang von Feldlinien des oben beschriebenen elektrischen Feldes. Diese Feldlinien können-ähnlich wie bei einem Plattenkondensator - an den Chipflanken auch halbkreisförmig ausgebildet sein. Vor allem die Migration entlang der Chipflanken wird vorliegend besonders effektiv unterbunden.

Ohne Maßnahmen gegen diese Migration, die vor allem in feuchter Umgebung verstärkt auftritt, werden die elektrischen und optischen Eigenschaften der reflektierenden Schicht 3 nach relativ kurzem Betrieb des optoelektronischen Halbleiterchips zerstört.

Als Maßnahme gegen die Migration ist nun ein Mittel 6 vorgesehen, das eine Abschirmung der reflektierenden Schicht 3 gegen das oben beschriebene elektrische Feld bewirkt. Damit wir eine Herauslösen von Metall aus der reflektierenden Schicht 3 gehemmt oder sogar verhindert. Vorliegend umfasst das Mittel 6 eine elektrisch isolierende Schicht 7, die auf Chipflanken 11 des Halbleiterkörpers 10 aufgebracht ist. Auf die dem Halbleiterkörper 10 abgewandte Seite der isolierenden Schicht 7 ist ein elektrisch leitendes Material 5 aufgebracht, das elektrisch direkt mit der zweiten Kontaktstelle 2 verbunden ist. Das heißt, auch das elektrisch leitende Material 5 befindet sich auf dem zweiten Potential U2, ebenso wie die zweite Kontaktstelle 2 und die reflektierende Schicht 3. Vorzugsweise erstreckt sich das elektrisch leitende Material zwischen der Unterseite 10b und der Oberseite 10a des Halbleiterkörpers 10 vollständig entlang der Chipflanken 11.

Das heißt, die Chipflanken 11 sind vollständig vom elektrisch leitenden Material 5 bedeckt.

Bei dem elektrisch leitenden Material 5 handelt es sich um ein strahlungsdurchlässiges, leitfähiges Oxid. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO3, ZnSnO₃ MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

TCO hat den Vorteil, dass an der Chipflanke 11 austretendes Licht nicht oder nur kaum absorbiert wird.

Auch die elektrisch isolierende Schicht 7 kann ebenso wie das elektrisch leitende Material 5 für die in der aktiven Zone 9 erzeugte elektromagnetische Strahlung durchlässig sein. Auf diese Weise kann das Mittel 6 also strahlungsdurchlässig sein.

Das elektrisch leitende Material 5 schirmt das elektrische Feld zwischen erster Kontaktstelle 1 und der reflektierenden Schicht 3 derart ab, dass eine Migration von Metall aus der reflektierenden Schicht 3 im Halbleiterkörper 10 im Vergleich zu einem optoelektronischen Halbleiterchip, der kein Mittel 6 aufweist, reduziert ist. Das heißt, die Migration im elektrischen Feld aufgrund des Potentialunterschieds zwischen erstem Potential U1 und zweitem Potential U2 ist gehemmt oder sogar unterbunden. Das heißt, der Mechanismus der Ionenmigration im elektrischen Feld wird verhindert, indem das elektrische Feld um die kritischen Stellen des Halbleiterchips herum abgeschirmt wird. Dies führt zu einem besonders kostengünstigen Halbleiterkörper, da eine aufwändige Verkapselung der reflektierenden Schicht gegen Migration von Metall aus der reflektierenden Schicht unterbleiben kann. Ferner ist gegenüber herkömmlichen optoelektronischen Halbleiterchips die leuchtende Fläche vergrößert, da weniger Sicherheitsabstände und Justagetoleranzen eingehalten werden müssen.

Bei herkömmlichen optoelektronischen Halbleiterchips, die einen Spiegel aufweisen, der ein zur Migration neigendes Metall enthält, ist der Spiegel 3 derart strukturiert, dass er zur Chipflanke 11 einen Sicherheitsabstand aufweist. Dieser Sicherheitsabstand stellt sicher, dass das Metall verpackt bleibt und beispielsweise bei Erzeugung der Chipflanke - zum Beispiel durch eine Mesa-Ätzung - nicht frei gelegt wird. Die Größe dieses Sicherheitsabstands ist bedingt durch die während der Prozessierung benötigten Toleranzen. Das heißt beispielsweise die Justage-Toleranz in der Fotolithographie zur Erzeugung der Chipflanken 11 und/oder die Toleranzen bei der Strukturierung der Chipflanken 11 gibt die Größe des Sicherheitsabstands vor. Typischerweise muss daher an jeder Chipflanke ein Sicherheitsabstand von zirka 10µm eingehalten werden. Dies verringert die tatsächlich kontaktierte Fläche und damit die Leuchtfläche des Chips. Daher ist beim hier beschriebenen Halbleiterchip gegenüber herkömmlichen optoelektronischen Halbleiterchips die leuchtende Fläche vergrößert.

Die Erhöhung der leuchtenden Fläche führt zu einer niedrigeren Stromdichte und gleichzeitig zu einer höheren Effizienz des optoelektronischen Halbleiterchips.

Das Mittel 6, das heißt die elektrisch isolierende Schicht 7 sowie das elektrisch leitende Material 5 schirmen das elektrische Feld zwischen der reflektierenden Schicht 3 und der ersten Kontaktstelle 1 ab.

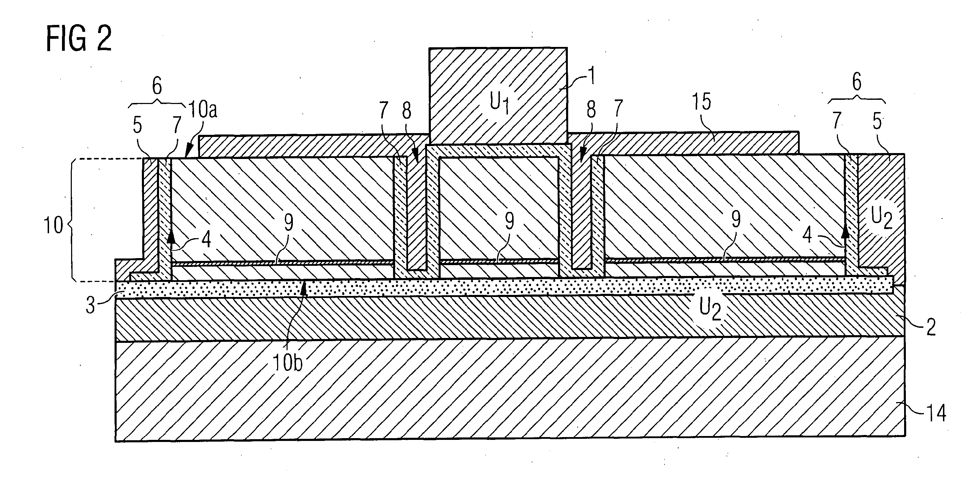

Das in Verbindung mit Figur 2 näher beschriebene zweite Ausführungsbeispiel eines hier beschriebenen optoelektronischen Halbleiterchips unterscheidet sich von dem in Verbindung mit Figur 1 beschriebenen Halbleiterchip dadurch, dass die reflektierende Schicht 3 unstrukturiert ist. In diesem Fall wird also eine reflektierende Schicht 3 ganzflächig auf die Unterseite 10b des Halbleiterkörpers 10 aufgebracht. Dies eröffnet die Möglichkeit, dass der optoelektronische Halbleiterchip in der Fertigung allein von seiner Oberseite 10a her strukturiert werden muss. Eine Justage von Strukturen an der Unterseite 10b des Halbleiterkörpers 10 zu Strukturen auf der Oberseite 10a-beispielsweise dem Ort der Kontaktstelle - kann also entfallen. Insbesondere kann beispielsweise eine Projektion 13 der ersten Kontaktstelle 1 auf die Unterseite 10b des Halbleiterkörpers 10 entfallen.

Im in Verbindung mit Figur 2 beschriebenen Ausführungsbeispiel ist ein Graben 8 von der Oberseite 10a in den Halbleiterkörper 10 eingebracht. Der Graben 8 erstreckt sich von der Oberseite 10a zur Unterseite 10b und durchbricht die aktive Zone 9. Darüber hinaus unterbricht der Graben im vorliegenden Fall den Halbleiterkörper vollständig. Das heißt, um die erste Kontaktstelle 1 ist ein beispielsweise ringförmiger Graben im Halbleiterkörper 10 erzeugt, der den Halbleiterkörper 10 durchbricht. Der Halbleiterkörper 10 ist im Bereich des Grabens 8, das heißt an den durch den Graben 8 gebildeten Chipflanken sowie an der Oberseite 10a des Halbleiterkörpers 10 mit einem elektrisch isolierenden Material 7 versehen. Auf diese Weise ist sichergestellt, dass im Bereich unter der Kontaktstelle 1 keine oder kaum elektromagnetische Strahlung erzeugt wird.

Die Stromaufweitung von der ersten Kontaktstelle 1 über die Oberseite 10a des Halbleiterkörpers 10 kann beispielsweise mittels eines transparenten leitfähigen Oxids (TCO) erfolgen. Ein solches TCO-Material kann auch beim Ausführungsbeispiel der Figur 1 zur Stromaufweitung von der Kontaktstelle 1 über die Oberseite 10a des Halbleiterkörpers 10 zum Einsatz kommen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 102008024327.2, deren Offenbarungsgehalt hiermit durch Rückbezug aufgenommen wird.

## Patentansprüche

1. Optoelektronischer Halbleiterchip mit
- einem Halbleiterkörper (10), an dessen Oberseite (10a) eine erste Kontaktstelle (1) und an dessen Unterseite (10b) eine zweite Kontaktstelle (2) angeordnet ist,
- einer reflektierenden Schicht (3), die sich in direktem Kontakt mit dem Halbleiterkörper (10) befindet und die direkt elektrisch leitend an die zweite Kontaktstelle (2) angeschlossen ist, wobei die reflektierende Schicht (3) ein zur Migration neigendes Metall enthält,
- einer Chipflanke (11), die sich zwischen Oberseite (10a) und Unterseite (10b) des Halbleiterkörpers (10) erstreckt, wobei an der Chipflanke (11) ein elektrisch leitendes Material (5) angeordnet ist, das mit der zweiten Kontaktstelle (2) direkt elektrisch leitend verbunden ist, **dadurch gekennzeichnet, dass**
- das elektrisch leitende Material (5) ein strahlungsdurchlässiges, leitfähiges Oxid ist.

2. Optoelektronischer Halbleiterchip nach dem vorherigen Anspruch,
bei dem um die erste Kontaktstelle (1) herum von der Oberseite (10a) des Halbleiterkörpers (10) her ein Graben (8) in den Halbleiterkörper (10) strukturiert ist.

3. Optoelektronischer Halbleiterchip nach dem vorherigen Anspruch,
bei dem der Graben (8) eine aktive Zone (9) des Halbleiterchips durchtrennt.

4. Optoelektronischer Halbleiterchip nach dem vorherigen Anspruch,
bei dem sich der Graben (8) bis zur reflektierenden Schicht (3) erstreckt.

5. Optoelektronischer Halbleiterchip nach einem der vorherigen Ansprüche,
bei dem zwischen der Chipflanke (11) und dem elektrisch leitenden Material (5) ein elektrisch isolierendes Material (7) angeordnet ist, das eine Kontaktierung des Hableiterkörpers (10) durch das elektrisch leitende Material (5) verhindert.

6. Optoelektronischer Halbleiterchip nach einem der vorherigen Ansprüche, bei dem
- sich im Betrieb des Halbleiterchips die erste Kontaktstelle (1) auf einem ersten elektrischen Potential (U1) befindet und
- die zweite Kontaktstelle (2), die reflektierende Schicht (3) und das elektrisch leitende Material (5) sich auf einem gemeinsamen zweiten elektrischen Potential (U2) befinden, wobei
- das erste elektrische Potential (U1) von zweiten elektrischen Potential (U2) verschieden ist.

7. Optoelektronischer Halbleiterchip nach einem der vorherigen Ansprüche,
bei dem die reflektierende Schicht (3) Silber enthält oder aus Silber besteht.

8. Optoelektronischer Halbleiterchip nach einem der vorherigen Ansprüche,
bei dem die reflektierende Schicht (3) strukturiert ist, derart dass die Unterseite (10b) des Halbleiterkörpers (10) im Bereich der Projektion (13) der ersten Kontaktstelle (1) auf die Unterseite (10b) frei von der reflektierenden Schicht (3) ist.

9. Optoelektronischer Halbleiterchip nach einem der vorherigen Ansprüche,
der in Dünnfilmbauweise ausgeführt ist.

10. Optoelektronischer Halbleiterchip nach dem vorherigen Anspruch,
bei dem ein Aufwachssubstrat vom epitaktisch gewachsenen Halbleiterkörper entfernt ist und der Halbleiterkörper mittels der zweiten Kontaktschicht (2) auf einem Träger (14) befestigt ist.

11. Optoelektronischer Halbleiterchip nach Anspruch 1,
bei dem am Halbleiterchip ein Mittel (6) vorgesehen ist, das im Betrieb des Halbleiterchips ein elektrisches Feld ausbildet, das der Migration des Metalls entgegenwirkt, wobei
- das Mittel (6) mit dem elektrisch leitenden Material (5) gebildet ist, das sich zwischen der ersten (1) und der zweiten Kontaktstelle (2) erstreckt.

## Claims

1. Optoelectronic semiconductor chip comprising
- a semiconductor body (10), at whose top side (10a) a first contact location (1) is arranged and at whose underside (10b) a second contact location (2) is arranged,
- a reflective layer (3), which is situated in direct contact with the semiconductor body (10) and which is directly electrically conductively connected to the second contact location (2), wherein the reflective layer (3) contains a metal that tends toward migration,
- a chip sidewall (11) extending between top side (10a) and underside (10b) of the semiconductor body (10), wherein an electrically conductive material (5) is arranged at the chip sidewall (11), said material being directly electrically conductively connected to the second contact location (2), **characterized in that**
- the electrically conductive material (5) is a radiation-transmissive, conductive oxide.

2. Optoelectronic semiconductor chip according to the preceding claim,
wherein a trench (8) is structured into the semiconductor body (10) around the first contact location (1) from the top side (10a) of the semiconductor body (10).

3. Optoelectronic semiconductor chip according to the preceding claim,
wherein the trench (8) severs an active zone (9) of the semiconductor chip.

4. Optoelectronic semiconductor chip according to the preceding claim,
wherein the trench (8) extends as far as the reflective layer (3).

5. Optoelectronic semiconductor chip according to any of the preceding claims,
wherein
an electrically insulating material (7) is arranged between the chip sidewall (11) and the electrically conductive material (5), said electrically insulating material preventing contact from being made with the semiconductor body (10) by means of the electrically conductive material (5).

6. Optoelectronic semiconductor chip according to any of the preceding claims, wherein
- during operation of the semiconductor chip the first contact location (1) is at a first electrical potential (U1) and
- the second contact location (2), the reflective layer (3) and the electrically conductive material (5) are at a common second electrical potential (U2), wherein
- the first electrical potential (U1) is different than the second electrical potential (U2).

7. Optoelectronic semiconductor chip according to any of the preceding claims,
wherein
the reflective layer (3) contains silver or consists of silver.

8. Optoelectronic semiconductor chip according to any of the preceding claims,
wherein
the reflective layer (3) is structured in such a way that the underside (10b) of the semiconductor body (10) is free of the reflective layer (3) in the region of the projection (13) of the first contact location (1) onto the underside (10b).

9. Optoelectronic semiconductor chip according to any of the preceding claims,
which is embodied in thin-film design.

10. Optoelectronic semiconductor chip according to the preceding claim,
wherein
a growth substrate is removed from the epitaxially grown semiconductor body and the semiconductor body is fixed on a carrier (14) by means of the second contact layer (2).

11. Optoelectronic semiconductor chip according to Claim 1,
wherein a means (6) which, during operation of the semiconductor chip, forms an electric field that counteracts the migration of the metal is provided at the semiconductor chip, wherein
- the means (6) is formed with the electrically conductive material (5) extending between the first (1) and the second contact location (2).

## Revendications

1. Puce à semi-conducteur optoélectronique comportant
- un corps semi-conducteur (10), à la face supérieure (10a) duquel est disposé un premier point de contact (1) et à la face inférieure (10b) duquel est disposé un deuxième point de contact (2),
- une couche réfléchissante (3) qui se trouve en contact direct avec le corps semi-conducteur (10) et qui est directement en connexion électroconductrice avec le deuxième point de contact (2), la couche réfléchissante (3) contenant un métal ayant tendance à la migration,
- un flanc de puce (11) qui s'étend entre la face supérieure (10a) et la face inférieure (10b) du corps semi-conducteur (10), sur le flanc de puce (11) étant disposé un matériau électroconducteur (5) qui est en liaison électroconductrice directe avec le deuxième point de contact (2), **caractérisée en ce que**
- le matériau électroconducteur (5) est un oxyde conducteur perméable aux rayonnements.

2. Puce à semi-conducteur optoélectronique selon la revendication précédente,
dans laquelle autour du premier point de contact (1) une tranchée (8) est formée dans le corps semi-conducteur (10) à partir de la face supérieure (10a) du corps semi-conducteur (10).

3. Puce à semi-conducteur optoélectronique selon la revendication précédente,
dans laquelle la tranchée (8) sectionne une zone active (9) de la puce à semi-conducteur.

4. Puce à semi-conducteur optoélectronique selon la revendication précédente,
dans laquelle la tranchée (8) s'étend jusqu'à la couche réfléchissante (3).

5. Puce à semi-conducteur optoélectronique selon l'une quelconque des revendications précédentes,
dans laquelle entre le flanc de puce (11) et le matériau électroconducteur (5) est disposé un matériau électro-isolant (7) qui empêche l'établissement d'un contact du corps semi-conducteur (10) par le matériau électroconducteur (5).

6. Puce à semi-conducteur optoélectronique selon l'une quelconque des revendications précédentes,
dans laquelle
- lors du fonctionnement de la puce à semi-conducteur le premier point de contact (1) se trouve à un premier potentiel électrique (U1) et
- le deuxième point de contact (2), la couche réfléchissante (3) et le matériau électroconducteur (5) se trouvent à un deuxième potentiel électrique (U2) commun,
- le premier potentiel électrique (U1) étant différent du deuxième potentiel électrique (U2).

7. Puce à semi-conducteur optoélectronique selon l'une quelconque des revendications précédentes,
dans laquelle la couche réfléchissante (3) contient de l'argent ou consiste en argent.

8. Puce à semi-conducteur optoélectronique selon l'une quelconque des revendications précédentes,
dans laquelle la couche réfléchissante (3) est configurée de telle sorte que dans la zone de la projection (13) du premier point de contact (1) sur la face inférieure (10b) la face inférieure (10b) du corps semi-conducteur (10) est exempte de la couche réfléchissante (3).

9. Puce à semi-conducteur optoélectronique selon l'une quelconque des revendications précédentes,
qui est réalisée en mode de construction en couche mince.

10. Puce à semi-conducteur optoélectronique selon la revendication précédente,
dans laquelle un substrat de croissance est éliminé du corps semi-conducteur formé par croissance épitaxiale et le corps semi-conducteur est fixé sur un support (14) au moyen de la deuxième couche de contact (2).

11. Puce à semi-conducteur optoélectronique selon la revendication 1,
dans laquelle sur la puce à semi-conducteur est prévu un moyen (6) qui lors du fonctionnement de la puce à semi-conducteur engendre un champ électrique qui s'oppose à la migration du métal, au cours de laquelle
- le moyen (6) étant formé avec le matériau électroconducteur (5) qui s'étend entre le premier (1) et le deuxième point de contact (2).
